# EUROPÄISCHE PATENTANMELDUNG

(11) **EP 2 043 210 A2**
(43) Veröffentlichungstag der Anmeldung: **01.04.2009**
(21) Anmeldenummer: 08165003.8
(22) Anmeldetag: 24.09.2008
(51) Int. Cl.: H01S 5/18, H01S 5/026, H01L 33/00

(54) **Halbleiterlaser und Verfahren zum Herstellen des Halbleiterlasers**

(30) Priorität: 28.09.2007 DE 102007046518; 21.12.2007 DE 102007062050
(71) Anmelder: OSRAM Opto Semiconductors GmbH, 93055 Regensburg (DE)
(72) Erfinder: Schmid, Wolfgang, 93180, Deuerling / Hillohe (DE); Brick, Peter, 93051, Regensburg (DE)
(74) Vertreter: Epping - Hermann - Fischer

(57) **Zusammenfassung**

Ein Halbleiterlaser ist als oberflächenemittierender Dünnfilm-Halbleiterlaser (2) mit einem Halbleiterkörper (4) ausgebildet. Der Halbleiterkörper (4) umfasst eine erste und eine zweite planare Oberfläche (12, 14). Zwischen den planaren Oberflächen umfasst der Halbleiterkörper (4) zur Erzeugung von Strahlung zumindest eine aktive Schicht (10). Zum Auskoppeln der Strahlung aus der aktiven Schicht (10) hin zu der ersten planaren Oberfläche (12) weist der Halbleiterkörper (4) zumindest eine zu der aktiven Schicht (10) geneigte erste Spiegelfläche (26) auf.

## Beschreibung

Die Erfindung betrifft einen Halbleiterlaser mit einem Halbleiterkörper.

Bei einem kantenemittierenden Halbleiterlaser tritt Strahlung, die in einer aktiven Schicht des Halbleiterlasers erzeugt wird, in Richtung parallel zu der aktiven Schicht aus einem Halbleiterkörper des kantenemittierenden Halbleiterlasers aus. Da ein Halbleiter grundsätzlich einen hohen Brechungsindex aufweist, wird ein großer Anteil der austretenden Strahlung an der Kante des Halbleiterlasers zurück in den Halbleiterkörper reflektiert, wodurch die Lasertätigkeit des Halbleiterlasers ermöglicht wird. Die Reflexion kann durch eine Oberflächenbeschichtung der Kanten des Halbleiterlasers beeinflusst werden. Dazu muss der Halbleiterlaser aus einem Waferverbund, in dem eine Schichtenfolge des Halbleiterkörpers epitaktisch aufgewachsen wird, herausgelöst werden. Erst dann sind die Kanten des Halbleiterlasers freigelegt und deren Oberfläche kann behandelt werden. Daher wird die Oberflächenbehandlung der Kanten grundsätzlich nicht im Waferverbund durchgeführt. Ferner werden die kantenemittierenden Halbleiterlaser grundsätzlich nicht im Waferverbund getestet.

Ferner tritt bei dem kantenemittierenden Halbleiterlaser die Strahlung in einem Austrittsbereich an der aktiven Schicht aus dem Halbleiterkörper aus. Insbesondere bei einer hohen Intensität der Strahlung und/oder bei einer langen Betriebsdauer kann dies einen Verschleiß, beispielsweise ein Schmelzen, der aktiven Schicht in dem Austrittsbereich begünstigen.

Das Schmelzen wird regelmäßig als COD (Catastrophic Optical Damage) bezeichnet.

Die Aufgabe, die der Erfindung zugrunde liegt, ist, einen Halbleiterlaser und ein Verfahren zum Herstellen des Halbleiterlasers zu schaffen, die dazu beitragen, dass der Halbleiterlaser als oberflächenemittierende Dünnfilm-Halbleiterlaser ausgebildet ist, einfach herstellbar und besonders beständig ist.

Die Aufgabe wird gelöst durch die Merkmale der unabhängigen Ansprüche. Vorteilhafte Ausgestaltungen sind in den Unteransprüchen angegeben.

Gemäß einem ersten Aspekt ist ein Halbleiterlaser vorgesehen, der als oberflächenemittierender Dünnfilm-Halbleiterlaser mit einem Halbleiterkörper ausgebildet ist. Der Halbleiterkörper umfasst eine erste und eine zweite planare Oberfläche. Zwischen den planaren Oberflächen umfasst der Halbleiterkörper zur Erzeugung von Strahlung zumindest eine aktive Schicht. Zum Auskoppeln der Strahlung aus der aktiven Schicht hin zu der ersten planaren Oberfläche weist der Halbleiterkörper zumindest eine zu der aktiven Schicht geneigte erste Spiegelfläche auf.

Dies ermöglicht, die erste planare Oberfläche, an der die Strahlung aus dem oberflächenemittierenden Dünnfilm-Halbleiterlaser austritt, im Waferverbund zu bearbeiten, beispielsweise die Spiegelflächen herzustellen, die oberflächenemittierenden Dünnfilm-Halbleiterlaser zu strukturieren und/oder die beiden planaren Oberflächen oder die Spiegelflächen inklusive Facettenprozess zu passivieren. Ferner können die oberflächenemittierenden Dünnfilm-Halbleiterlaser im Waferverbund getestet werden. Dies trägt zu einer besonders einfachen und somit günstigen Herstellung des oberflächenemittierenden Dünnfilm-Halbleiterlasers bei. Ferner kann dies dazu beitragen, die Reflexion in einem Austrittsbereich der Strahlung zu beeinflussen. Ferner kann die erste Spiegelfläche dazu beitragen, dass an der ersten planaren Oberfläche kein COD auftritt. Dies trägt dazu bei, dass der oberflächenemittierende Dünnfilm-Halbleiterlaser besonders beständig ist, beispielsweise gegenüber Verschleiß, insbesondere Schmelzen, insbesondere bei einer langen Betriebsdauer und/oder bei einer hohen Intensität der Strahlung.

Die erste Spiegelfläche ist durch eine Außenfläche des Halbleiterkörpers gebildet, die zu der ersten und der zweiten planaren Oberfläche geneigt ist. Ein Reflexionsgrad der ersten Spiegelfläche kann erhöht werden, indem eine dielektrische und/oder metallische Oberfläche auf die erste Spiegelfläche aufgebracht wird. Die erste und gegebenenfalls weitere Spiegelflächen können passiviert werden, beispielsweise indem Sauerstoffatome von deren Oberfläche entfernt werden. Dass die aktive Schicht zwischen den planaren Oberflächen ausgebildet ist, bedeutet in diesem Zusammenhang, dass die aktive Schicht in einer Projektion auf die planaren Oberflächen einen Überlappungsbereich mit den planaren Oberflächen bildet.

In einer Ausgestaltung weist der Halbleiterkörper zum Auskoppeln von Strahlung aus der aktiven Schicht hin zu der ersten planaren Oberfläche eine zu der aktiven Schicht geneigte zweite Spiegelfläche auf. Dies ermöglicht, dass die Strahlung an unterschiedlichen Kanten der aktiven Schicht mittels der Spiegelflächen aus der aktiven Schicht ausgekoppelt wird. Dies kann zu einer besonders hohen Intensität der von dem oberflächenemittierenden Dünnfilm-Halbleiterlaser abgestrahlten Strahlung und/oder zu einer hohen Effizienz des oberflächenemittierenden Dünnfilm-Halbleiterlasers beitragen. Die zweite Spiegelfläche kann gemäß der ersten Spiegelfläche ausgebildet sein.

In einer weiteren Ausgestaltung ist zumindest eine der Spiegelflächen so ausgebildet, dass eine Hauptabstrahlrichtung der von dem oberflächenemittierenden Dünnfilm-Halbleiterlaser abgestrahlten Strahlung senkrecht auf der ersten planaren Oberfläche des Halbleiterkörpers steht. Dies kann zu einem besonders hohen Strahlungsfluss der von dem oberflächenemittierenden Dünnfilm-Halbleiterlaser abgestrahlten Strahlung beitragen, da senkrecht zu der ersten planaren Oberfläche innerhalb des Halbleiterkörpers die austretende Strahlung die geringstmögliche Strecke zurücklegt und somit möglichst wenig mit dem Halbleiterkörper wechselwirkt.

In einer weiteren Ausgestaltung ist zumindest eine der Spiegelflächen in einem Winkel von 35 bis 55 Grad zu der aktiven Schicht geneigt. Vorzugsweise beträgt der Winkel 45 Grad. Dies ermöglicht einfach, die Spiegelflächen so auszubilden, dass die Hauptabstrahlrichtung der von dem oberflächenemittierende Dünnfilm-Halbleiterlaser abgestrahlten Strahlung senkrecht auf der ersten planaren Oberfläche des Halbleiterkörpers steht.

In einer weiteren Ausgestaltung weist der Halbleiterkörper eine Dünnfilmschichtenfolge auf, die die aktive Schicht umfasst. Die Dünnfilmschichtenfolge wird vorzugsweise auf einem Aufwachssubstrat aufgewachsen und ermöglicht, die aktive Schicht besonders präzise herzustellen. Vorzugsweise umfasst die Dünnfilmschichtenfolge zumindest zwei Wellenleiterschichten, in die die aktive Schicht in Richtung einer Flächennormalen der Schichten eingebettet ist. Ferner sind die Wellenleiterschichten und die aktive Schicht in Richtung der Flächennormalen zwischen mindestens zwei Mantelschichten eingebettet. Die Wellenleiterschichten weisen typischerweise einen größeren Brechungsindex als die Mantelschichten auf, wodurch ein Brechungsindexsprung zwischen den Wellenleiterschichten und den angrenzenden Mantelschichten entsteht. Dies bewirkt eine Führung der Strahlung in lateraler Richtung senkrecht zu der Flächennormalen.

Vorzugsweise sind die Halbleiter der einzelnen Schichten des Halbleiterkörpers dotiert. Beispielsweise ist eine der Mantelschichten n-dotiert und die andere ist p-dotiert. Die dotierten Halbleiter ermöglichen eine besonders hohe Rekombinationsrate von positiven und negativen Ladungsträgern, die in der aktiven Schicht rekombinieren und so die Strahlung erzeugen. Die Mantelschichten können dazu beitragen, einen ungewünschten Fluss von Ladungsträgern zu vermeiden und somit noch weiter die Rekombinationsrate zu erhöhen. Abhängig von den Dotierungen wird zum Erzeugen der Strahlung eine Spannung so an den Halbleiterkörper angelegt, dass vorzugsweise möglichst viele Ladungsträger in der aktiven Schicht rekombinieren.

Der Zusatz "Dünnfilm" bei dem oberflächenemittierenden Dünnfilm-Halbleiterlaser bedeutet, dass die Dünnfilmschichtenfolge beispielsweise dünner als 20 Mikrometer sein kann.

In einer weiteren Ausgestaltung umfasst die Dünnfilmschichtenfolge zwei oder mehrere aktive Schichten, in denen die Strahlung erzeugt wird und die durch in der Dünnfilmschichtenfolge monolithisch integrierte Tunnelübergänge elektrisch miteinander gekoppelt sind. Dies ermöglicht einfach, einen in der Dünnfilmschichtenfolge erzeugten Strahlungsfluss zu erhöhen. Die zwei oder mehreren aktiven Schichten sind vorzugsweise jeweils in eigene Wellenleiterschichten und entsprechende Mantelschichten eingebettet. Dadurch entstehen jedoch pn- oder np-Übergänge an aneinandergrenzenden unterschiedlich dotierten Mantelschichten. Abhängig von der angelegten Spannung an dem Halbleiterkörper sind die pn- bzw. np-Übergänge in Sperrrichtung hintereinander geschaltet. Die Tunnelübergänge sind zwischen den aneinander grenzenden unterschiedlich dotierten Mantelschichten ausgebildet und ermöglichen einen Ladungsträgerfluss über die in Sperrrichtung hintereinander angeordneten Übergänge.

In einer weiteren Ausgestaltung umfasst der Halbleiterkörper eine Funktionsschicht. Eine von der Dünnfilmschichtenfolge abgewandte Seite der Funktionsschicht bildet die erste planare Oberfläche des Halbleiterkörpers. Die Funktionsschicht kann dazu beitragen, die Dünnfilmschichtenfolge besonders einfach herzustellen. Ferner kann die Funktionsschicht dazu beitragen, dass eine Elektrode zum Kontaktieren des oberflächenemittierenden Dünnfilm-Halbleiterlasers im Vergleich zu der aktiven Schicht eine relativ kleine Fläche aufweisen kann und dennoch in der gesamten aktiven Schicht Ladungsträgerrekombination und somit Strahlungserzeugung stattfinden kann.

In einer weiteren Ausgestaltung ist die Funktionsschicht in einem Gebiet schmaler, in dem während eines Betriebs des oberflächenemittierenden Dünnfilm-Halbleiterlasers ein Hauptstrahlungsfluss aus der aktiven Schicht ausgekoppelter Strahlung austritt, als außerhalb des Gebietes. Dies trägt besonders einfach dazu bei, dass die Intensität des oberflächenemittierenden Dünnfilm-Halbleiterlasers besonders hoch ist, da die Strahlung innerhalb des Halbleiterkörpers weniger Weg zurücklegen muss und weniger mit dem Halbleiterkörper wechselwirkt.

In einer weiteren Ausgestaltung umfasst die Funktionsschicht ein Aufwachssubstrat. Das Aufwachssubstrat trägt dazu bei, dass die Dünnfilmschichtenfolge besonders präzise herstellbar ist.

In einer weiteren Ausgestaltung umfasst die Funktionsschicht eine Stromaufweitungsschicht. Die Stromaufweitungsschicht zeichnet sich dadurch aus, dass sie in einer Ebene parallel zu der aktiven Schicht eine besonders hohe elektrische Leitfähigkeit aufweist. Dies trägt dazu bei, dass Ladungsträger, deren Bewegung durch eine von außen angelegte Spannung in dem Halbleiterkörper induziert wird, sich auf die gesamte aktive Schicht verteilen und somit Ladungsträgerrekombination in der gesamten aktiven Schicht bewirken. Dies ermöglicht, dass die Elektrode zum Anlegen der äußeren Spannung im Verhältnis zu der aktiven Schicht relativ klein ausgebildet werden kann.

In einer weiteren Ausgestaltung ist der Halbleiterkörper mit seiner zweiten planaren Oberfläche mit einem Trägersubstrat gekoppelt. Das Trägersubstrat ermöglicht, das Aufwachssubstrat nach dem Aufwachsen der Dünnfilmschichtenfolge und der Koppelung mit dem Trägersubstrat zu entfernen. Die erste planare Oberfläche des Halbleiterkörpers ist dann durch eine Seite der Dünnfilmschichtenfolge oder gegebenenfalls durch eine Seite der Stromaufweitungsschicht gebildet. Dies ermöglicht, dass die Strahlung innerhalb des Halbleiterkörpers nicht mehr durch das Aufwachssubstrat dringen muss, um aus dem Halbleiterkörper auszutreten. Dies kann zu einem besonders hohen Strahlungsfluss der abgestrahlten Strahlung beitragen. Ferner kann dies dazu beitragen, im Halbleiterkörper entstehende Wärme besonders effektiv abzuleiten, da das Trägersubstrat beispielsweise ein Metall umfassen kann.

In einer weiteren Ausgestaltung umfasst der oberflächenemittierende Dünnfilm-Halbleiterlaser an zumindest einer ersten Grenzfläche des Halbleiterkörpers zumindest eine erste optisch wirksame Schicht mit einem vorgegebenen ersten Reflexionsgrad. Die erste optisch wirksame Schicht ist so angeordnet, dass aus der aktiven Schicht ausgekoppelte Strahlung mittels der ersten Spiegelfläche hin zu der ersten optisch wirksamen Schicht gespiegelt wird. Dies ermöglicht, einen Reflexionsgrad der ersten Grenzfläche zu erhöhen oder zu erniedrigen. Dies ermöglicht, die Eigenschaften des oberflächenemittierenden Dünnfilm-Halbleiterlasers mittels der optisch wirksamen Schicht besonders flexibel einstellen zu können. Die optische Wirksamkeit der optisch wirksamen Schicht ist in diesem Zusammenhang auf den Einfluss der optisch wirksamen Schicht auf die Reflektion der Strahlung an der ersten Grenzfläche bezogen.

In einer weiteren Ausgestaltung ist an der ersten Grenzfläche eine zweite optisch wirksame Schicht mit einem zweiten vorgegebenen Reflexionsgrad so angeordnet, dass aus der aktiven Schicht ausgekoppelte Strahlung mittels der zweiten Spiegelfläche hin zu der zweiten optisch wirksamen Schicht gespiegelt wird. Dies trägt dazu bei, dass die Eigenschaften des oberflächenemittierenden Dünnfilm-Halbleiterlasers besonders flexibel einstellbar sind. Insbesondere kann der zweite vorgegebene Reflexionsgrad weit größer vorgegeben werden als der erste vorgegebene Reflexionsgrad der ersten optisch wirksamen Schicht. Dies führt dazu, dass die aus der aktiven Schicht ausgekoppelte Strahlung nahezu total an der zweiten optisch wirksamen Schicht reflektiert wird und wieder in die aktive Schicht eingekoppelt wird. Dies führt dazu, dass ein Strahlungsfluss, der über die erste Spiegelfläche ausgekoppelten Strahlung nahezu verdoppelt wird, und somit der oberflächenemittierende Dünnfilm-Halbleiterlaser eine 1-Punkt-Lichtquelle mit besonders hoher Intensität und/oder Strahlungsausbeute darstellt.

In einer weiteren Ausgestaltung ist die zweite optisch wirksame Schicht mit dem zweiten vorgegebenen Reflexionsgrad so an einer zweiten Grenzfläche des Halbleiterkörpers angeordnet, dass aus der aktiven Schicht ausgekoppelte Strahlung mittels der zweiten Spiegelfläche hin zu der zweiten optisch wirksamen Schicht gespiegelt wird. Die zweite optisch wirksame Schicht an der zweiten Grenzfläche hat die selben Eigenschaften und/oder Vorteile wie die zweite optisch wirksame Schicht an der ersten Grenzfläche. Ferner können an der ersten und/oder der zweiten Grenzfläche die erste, die zweite und/oder weitere optisch wirksame Schichten in beliebiger Kombination ausgebildet sein.

In einer weiteren Ausgestaltung ist zumindest eine der Grenzflächen durch eine der optisch wirksamen Schichten und die erste planare Oberfläche des Halbleiterkörpers gebildet. Dies trägt dazu bei, dass an dem Übergang von dem Halbleiterkörper mit dem besonders hohen Brechungsindex hin zu einer Umgebung des Halbleiterkörpers mit einem besonders niedrigen Brechungsindex vorzugsweise möglichst wenig Strahlung zurück in den Halbleiterkörper reflektiert wird.

In einer weiteren Ausgestaltung des ersten Aspekts umfasst der Halbleiterkörper zumindest eine der optisch wirksamen Schichten. Dies kann dazu beitragen, die optisch wirksamen Schichten besonders einfach herzustellen, insbesondere durch epitaktisches Wachstum.

In einer weiteren Ausgestaltung umfasst der Halbleiterkörper zumindest eine erste Linse, die so ausgebildet ist, dass ein Hauptstrahlungsfluss der aus der aktiven Schicht ausgekoppelten Strahlung die erste Linse durchdringt. Die Linse ermöglicht einfach die Strahlung beim Austritt aus dem Halbleiterkörper zu fokussieren oder zu defokussieren. Ein, zwei oder mehrere optisch wirksamen Schichten können auch auf der Linse angeordnet sein. Ferner können mehrere Linsen vorgesehen sein, beispielsweise jeder Spiegelfläche und der entsprechenden ausgekoppelten Strahlung zugeordnet eine Linse.

In einer weiteren Ausgestaltung umfasst der oberflächenemittierende Dünnfilm-Halbleiterlaser zumindest eine Monitordiode zum Detektieren von Strahlung aus der aktiven Schicht. Dies kann einfach dazu beitragen, den oberflächenemittierenden Dünnfilm-Halbleiterlaser im geregelten Betrieb zu betreiben. Ferner ermöglicht dies einfach, die in der aktiven Schicht erzeugte Strahlung zu ermitteln.

In einer weiteren Ausgestaltung umfasst der Halbleiterkörper einen Strahlungserzeugungsbereich. Über den Strahlungserzeugungsbereich sind eine erste und eine zweite Elektrode elektrisch miteinander gekoppelt. Ferner umfasst der oberflächenemittierende Dünnfilm-Halbleiterlaser einen Monitorbereich des Halbleiterkörpers. Der Monitorbereich ist zumindest durch eine Unterbrechung der Dünnfilmschichtenfolge von dem Strahlungsbereich abgetrennt. Über den Monitorbereich sind eine erste und eine zweite Monitorelektrode miteinander elektrisch gekoppelt. Dies ermöglicht einfach, die Strahlung zu erfassen und/oder den oberflächenemittierenden Dünnfilm-Halbleiterlaser zu regeln.

In einer weiteren Ausgestaltung umfasst der Halbleiterkörper den Strahlungserzeugungsbereich, über den die erste und die zweite Elektrode elektrisch miteinander gekoppelt sind. Ferner umfasst der Halbleiterkörper den Monitorbereich, der eine dritte Monitorelektrode und eine strahlungsreaktive Schicht an der dritten Monitorelektrode umfasst. Die strahlungsreaktive Schicht ist so ausgebildet, dass Strahlung, die mittels der zweiten Spiegelfläche aus dem aktiven Bereich ausgekoppelt wird, hin zu der strahlungsreaktiven Schicht gespiegelt wird. Dies ermöglicht einfach, die in der aktiven Schicht erzeugte Strahlung zu erfassen und/oder den oberflächenemittierenden Dünnfilm-Halbleiterlaser zu regeln. Die strahlungsreaktive Schicht wird vorzugsweise durch epitaktisches Wachstum auf das Aufwachssubstrat aufgebracht.

Gemäß zumindest einer Ausführungsform des Halbleiterlasers weist dieser eine geneigte erste Spiegelfläche und eine geneigte zweite Spiegelfläche auf, wobei sowohl über die erste als auch über die zweite geneigte Spiegelfläche die in der mindestens einen aktiven Schicht erzeugte Strahlung zur ersten planaren Oberfläche reflektiert wird. Die von den Spiegelflächen reflektierte Strahlung trifft senkrecht auf die erste Oberfläche. Sowohl von der ersten als auch von der zweiten Spiegelfläche reflektierte Strahlung wird zumindest teilweise an der ersten Oberfläche ausgekoppelt. Die Neigung der Spiegelflächen bezüglich der ersten Oberfläche beträgt, im Rahmen der Herstellungstoleranzen, bevorzugt 45 °. Hierdurch ist eine besonders intensive Abstrahlung des Halbleiterlasers ermöglicht.

Gemäß zumindest einer Ausführungsform des Halbleiterlasers umfasst dieser mindestens eine Monitordiode, die sich lateral neben der mindestens einen Strahlung erzeugenden aktiven Schicht befindet. Mit anderen Worten ist die Monitordiode, in einer Richtung senkrecht zu einer Verbindungslinie zwischen erster und zweiter geneigter Spiegelfläche, bezüglich der aktiven Schicht versetzt. Die Monitordiode empfängt Strahlung, die etwa über Streuung lateral aus der aktiven Schicht emittiert wird. Über eine solche Anordnung der Monitordiode ist ein leistungsstarker und kompakt aufgebauter Halbleiterlaser realisierbar.

Gemäß einem zweiten Aspekt ist ein Verfahren zum Herstellen des Halbleiterlasers vorgesehen, der als oberflächenemittierender Dünnfilm-Halbleiterlaser ausgebildet ist. Der Halbleiterkörper wird durch epitaktisches Wachstum der Dünnfilmschichtenfolge auf dem Aufwachssubstrat ausgebildet. Die zweite planare Oberfläche des Halbleiterkörpers ist von dem Aufwachssubstrat abgewandt. Es wird zumindest die erste Spiegelfläche von der zweiten planaren Oberfläche aus durch Entfernen von Halbleitermaterial aus der Dünnfilmschichtenfolge gebildet. Dies trägt dazu bei, dass der oberflächenemittierende Dünnfilm-Halbleiterlaser im Waferverbund ausgebildet werden kann. Ferner werden vorzugsweise die Oberflächen und die Spiegelflächen im Waferverbund bearbeitet, beispielsweise passiviert.

In einer Ausgestaltung wird das Trägersubstrat auf die zweite planare Oberfläche aufgebracht. Danach wird das Aufwachssubstrat von der Dünnfilmschichtenfolge abgetrennt. Dies trägt dazu bei, dass die aus der aktiven Schicht ausgekoppelte Strahlung vorzugsweise möglichst wenig Weg innerhalb des Halbleiterkörpers zurücklegen muss und somit vorzugsweise möglichst wenig mit dem Halbleiterkörper wechselwirkt. Dies kann besonders wirkungsvoll dazu beitragen, dass die von dem oberflächenemittierenden Dünnfilm-Halbleiterlaser abgestrahlte Strahlung eine besonders hohe Intensität hat. Ferner kann der oberflächenemittierende Dünnfilm-Halbleiterlaser besonders schmal, beispielsweise schmäler als 20 Mikrometer ausgebildet werden.

In einer weiteren Ausgestaltung wird der oberflächenemittierende Dünnfilm-Halbleiterlaser im Waferverbund hergestellt. Der oberflächenemittierende Dünnfilm-Halbleiterlaser wird nach Aufbringen des Trägersubstrats aus dem Waferverbund herausgelöst. Dies ermöglicht eine besonders präzise und günstige Herstellung des oberflächenemittierenden Dünnfilm-Halbleiterlasers. Ferner ermöglicht dies, im Gegensatz zu dem Aufwachssubstrat, als Material für das Trägersubstrat ein Metall zu verwenden.

In einer weiteren Ausgestaltung wird vor dem Aufbringen des Trägersubstrats zumindest die zweite Elektrode auf die zweite planare Oberfläche des Halbleiterkörpers aufgebracht. Dies trägt dazu bei, dass die zweite Elektrode möglichst nahe an der Dünnfilmschichtenfolge ist.

In einer weiteren Ausgestaltung wird vor dem Aufwachsen der Dünnfilmschichtenfolge die strahlungsreaktive Schicht durch epitaktisches Wachstum auf das Aufwachssubstrat aufgebracht. Die Stromaufweitungsschicht wird auf die strahlungsreaktive Schicht aufgebracht. Die Dünnfilmschichtenfolge wird durch epitaktisches Wachstum auf der Stromaufweitungsschicht ausgebildet. Nach dem Entfernen des Aufwachssubstrats wird die strahlungsreaktiven Schicht außerhalb des Bereichs entfernt, der für die dritte Monitorelektrode vorgesehen ist. Außerhalb der strahlungsreaktiven Schicht wird die erste Elektrode auf der Funktionsschicht ausgebildet. Die dritte Monitorelektrode wird auf der strahlungsreaktiven Schicht ausgebildet. Dies ermöglicht besonders einfach das Erfassen der Strahlung und/oder die Regelung des oberflächenemittierenden Halbleiterlasers.

Ausführungsbeispiele sind im Folgenden anhand von schematischen Zeichnungen näher erläutert.

### Es zeigen:

- Figur 1: einen Schnitt durch eine erste Ausführungsform eines Halbleiterlasers,
- Figur 2: eine weitere Ansicht der ersten Ausführungsform des Halbleiterlasers,
- Figur 3: einen Schnitt durch eine zweite Ausführungsform des Halbleiterlasers,
- Figur 4: einen Schnitt durch eine dritte Ausführungsform des Halbleiterlasers,
- Figur 5: einen Schnitt durch eine vierte Ausführungsform des Halbleiterlasers,
- Figur 6: einen Schnitt durch eine fünfte Ausführungsform des Halbleiterlasers,
- Figur 7: einen Schnitt durch eine sechste Ausführungsform des Halbleiterlasers,

- Figur 8: einen Schnitt durch eine siebte Ausführungsform des Halbleiterlasers,
- Figur 9: einen Schnitt durch eine achte Ausführungsform des Halbleiterlasers,
- Figur 10: einen Schnitt durch eine neunte Ausführungsform des oberflächenemittierenden Dünnfilm-Halbleiterlasers,
- Figur 11: einen Schnitt durch eine zehnte Ausführungsform des Halbleiterlasers,
- Figur 12: einen Schnitt durch eine elfte Ausführungsform des Halbleiterlasers,
- Figur 13: einen Schnitt durch eine erste Ausführungsform des Halbleiterlasers mit Monitorelektrode,
- Figur 14: einen Schnitt durch eine zweite Ausführungsform des Halbleiterlasers mit Monitorelektrode,
- Figur 15: einen Schnitt durch eine dritte Ausführungsform des Halbleiterlasers mit Monitordiode,
- Figur 16: ein Ablaufdiagramm eines Verfahrens zum Herstellen des Halbleiterlasers.

Elemente gleicher Konstruktion oder Funktion sind figurenübergreifend mit den gleichen Bezugszeichen gekennzeichnet.

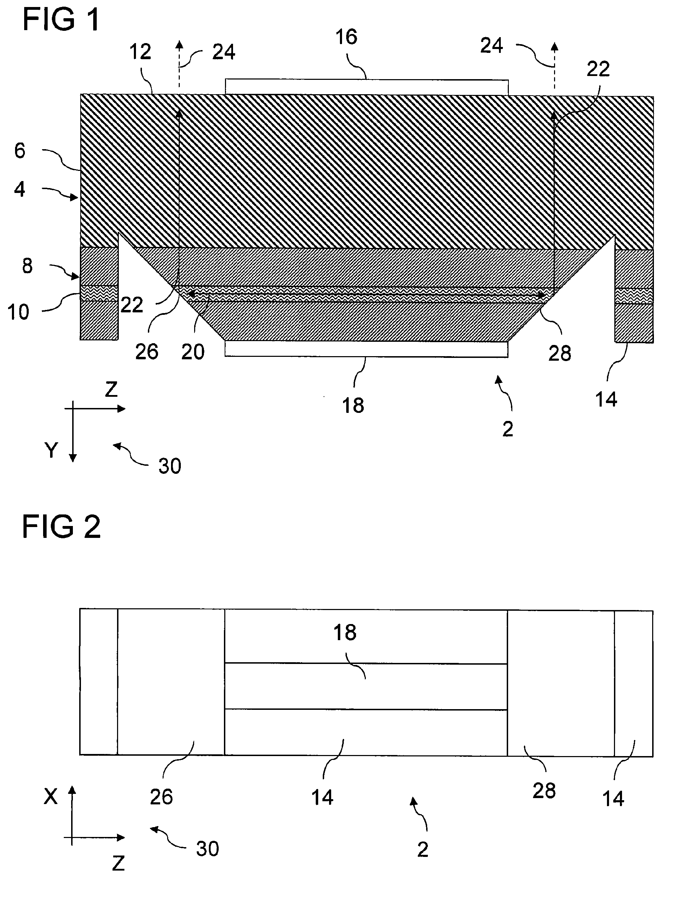

Ein Halbleiterlaser ist vorzugsweise als oberflächenemittierender Dünnfilm-Halbleiterlaser 2 (Figur 1) ausgebildet und umfasst einen Halbleiterkörper 4. Der Halbleiterkörper 4 kann eine Funktionsschicht 6 umfassen. Die Funktionsschicht 6 kann alternativ dazu während eines Herstellungsprozesses zum Herstellen des oberflächenemittierenden Dünnfilm-Halbleiterlasers 2 zunächst vorhanden sein und dann zumindest teilweise entfernt werden. Ferner umfasst der Halbleiterkörper 4 eine Dünnfilmschichtenfolge 8 mit zumindest einer aktiven Schicht 10.

Der Halbleiterkörper 4 bildet eine erste planare Oberfläche 12, die durch eine einer zweiten planaren Oberfläche 14 abgewandte Seite des Halbleiterkörpers 4 gebildet ist. Zum Erzeugen von Strahlung wird der Halbleiterkörper 4 vorzugsweise über eine erste Elektrode 16 und eine zweite Elektrode 18 mit Energie versorgt. Dazu wird beispielsweise eine Spannung an die beiden Elektroden angelegt. Zusätzlich zu der aktiven Schicht 10 umfasst die Dünnfilmschichtenfolge 8 vorzugsweise eine Mantelschicht, die zwischen der aktiven Schicht 10 und der Funktionsschicht 6 ausgebildet ist, und eine weitere Mantelschicht, die zwischen der aktiven Schicht 10 und der zweiten Elektrode 18 ausgebildet ist. Zwischen den beiden Mantelschichten und der aktiven Schicht 10 ist vorzugsweise jeweils eine Wellenleiterschicht ausgebildet. Die aktive Schicht 10 umfasst im wesentlichen einen, zwei oder mehrere Quantenfilme, Quantenpunkte und/oder Quantenstreifen. In anderen Worten kann die Quantisierung ein, zwei oder dreidimensional ausgebildet sein.

Die Schichten des Halbleiterkörpers 4 sind vorzugsweise dotiert. Beispielsweise ist eine der beiden Mantelschichten n-dotiert und die andere p-dotiert. Abhängig davon, welche der beiden Mantelschichten p-dotiert ist und welche n-dotiert ist, wird die Polung der beiden Elektroden so gewählt, dass aufgrund der angelegten Spannung positive Ladungsträger aus dem p-dotierten Bereich und negative Ladungsträger aus dem n-dotierten Bereich hin zu der aktiven Schicht 10 wandern und dort rekombinieren. Ferner kann die Funktionsschicht 6 zumindest teilweise dotiert sein. Die Dotierung aller dotieren Schichten des Halbleiterkörpers 4 auf derselben Seite der aktiven Schicht 10 ist qualitativ vorzugsweise gleich, also entweder p-dotiert oder n-dotiert, und die Dotierung der Schichten auf der anderen Seite der aktiven Schicht 10 ist entgegengesetzt dotiert. Durch die Rekombination der Ladungsträger in der aktiven Schicht 10 wird Strahlung 20 in der aktiven Schicht 10 erzeugt. Die Mantelschichten verhindern ein entgegen gesetztes Wandern der freien Ladungsträger und erhöhen somit die Rekombinationsrate in der aktiven Schicht 10. Ferner weisen die Wellenleiterschichten vorzugsweise einen höheren Brechungsindex als die Mantelschichten auf. Dies bewirkt eine laterale Führung der Strahlung 20 in der aktiven Schicht 10 senkrecht zu einer Flächennormalen der Schichten der Dünnfilmschichtenfolge 8.

Die Strahlung 20 innerhalb der aktiven Schicht 10 wird durch Spiegelung zumindest an einer ersten Spiegelfläche 26 und vorzugsweise an einer zweiten Spiegelfläche 28 aus der aktiven Schicht 10 ausgekoppelt. Eine aus der aktiven Schicht ausgekoppelte Strahlung 22 wird vorzugsweise in Richtung senkrecht zu der ersten planaren Oberfläche 12 reflektiert. Damit der oberflächenemittierende Dünnfilm-Halbleiterlaser 2 mit einer vorzugsweise möglichst hohen Intensität betrieben werden kann, wird vorzugsweise die erste planare Oberfläche 12 in einem Austrittsbereich der Strahlung 24 passiviert, d.h. dass beispielsweise Sauerstoffatome von der Oberfläche entfernt werden, beispielsweise mittels einer Wasserstoff-Reinigung. Die Spiegelflächen 26, 28 können auch als totalreflektierende Mesaflanken bezeichnet werden. Die Spiegelflächen 26, 28 sind zu der aktiven Schicht 10 geneigt ausgebildet und schließen vorzugsweise einen Winkel von 45 Grad mit der aktiven Schicht 10 ein. Der Winkel kann aber auch zwischen beispielsweise 35 und 55 Grad variieren. Vorzugsweise ist ein Abstand der Spiegelflächen 26, 28 zu einander so gewählt, dass in die aktive Schicht 10 zurückreflektierte Strahlung 20 die Strahlungserzeugung verstärkt.Die erste und/oder die zweite Spiegelfläche 26, 28 können lediglich durch die Grenzfläche zwischen Halbleiterkörper 4 und Umgebung des Halbleiterkörpers 4 gebildet sein. Es kann jedoch auch eine dielektrische Schicht auf die Spiegelflächen 26, 28 und/oder gegebenenfalls eine Metallschicht auf die dielektrische Schicht aufgebracht werden. Vorzugsweise werden die Spiegelflächen 26, 28 passiviert.

Die beiden Elektroden können schichtweise aufgebaut sein. Beispielsweise kann die Elektrode, an die ein positives Potenzial angelegt wird, eine Chrom- oder Titanschicht umfassen, die als Haftvermittler und elektrischer Kontakt zu dem Halbleiterkörper fungiert. Auf die Chromschicht kann dann eine Platinschicht folgen, die als Diffusionssperre wirkt. Die Platinschicht kann dann mit einer Goldschicht überzogen werden, die einfach ein Kontaktieren der Elektrode mit der Strom- und/oder Spannungsversorgung beispielsweise durch Bonden ermöglicht. Die zweite Elektrode 18 kann so beispielsweise mit einem Trägersubstrat gekoppelt werden.

Die Elektrode, die mit dem negativen Potenzial verbunden ist, umfasst vorzugsweise Gold, Nickel, Titan und/oder Germanium.

Die n-dotierte Mantelschicht umfasst beispielsweise Aluminium-Gallium-Arsenid mit einem Aluminiumanteil von 40 %. Die p-dotierte Mantelschicht kann ebenfalls Aluminium-Gallium-Arsenid mit einem Aluminiumgehalt von 40 % umfassen. Die beiden Wellenleiterschichten können Aluminium-Gallium-Arsenid mit einem Aluminiumanteil von 20 % umfassen. Die aktive Schicht 10, insbesondere deren Quantenfilm umfasst beispielsweise Indium-Gallium-Arsenid mit einem Indiumanteil von 10 %. Alternativ dazu kann zum Erzeugen einer roten Laserstrahlung die aktive Schicht 10 Indium-Gallium-Aluminium-Phosphid umfassen. Zum Erzeugen einer Strahlung im Infrarotbereich kann die aktive Schicht 10 auch Indium-Aluminium-Gallium-Arsenid umfassen. Ferner können zum Erzeugen anderer Farben auch andere Materialkombinationen verwendet werden.

Die Funktionsschicht 6 weist beispielsweise eine Dicke von 100 Mikrometer auf. Die Mantelschichten und die Wellenleiterschichten können beispielsweise eine Dicke von 1 Mikrometer aufweisen. Die aktive Schicht 10, insbesondere deren Quantenfilm, weist beispielsweise eine Dicke von 10 Nanometer auf. Da die Dünnfilmschichtenfolge 8 vorzugsweise derart dünn ausgebildet ist, wird der Bezeichnung "oberflächenemittierender Halbleiterlaser" der Zusatz "Dünnfilm" beigefügt.

Ein Koordinatensystem 30 kennzeichnet eine Ausrichtung des oberflächenemittierenden Dünnfilm-Halbleiterlasers 2.

In einer weiteren Ansicht des oberflächenemittierenden Dünnfilm-Halbleiterlasers 2 (Figur 2) ist zu erkennen, dass die zweite Elektrode 18 nicht die gesamte Breite der zweiten planaren Oberfläche 14 bedecken muss. Ferner kann die Dünnfilmschicht 8 beispielsweise lediglich im Überlappungsbereich mit der zweiten Elektrode 18 die volle Dicke aufweisen und außerhalb des Überlappungsbereichs schmäler ausgebildet sein. Dadurch kann die Strahlung in der Dünnfilmschicht 8 geführt werden.

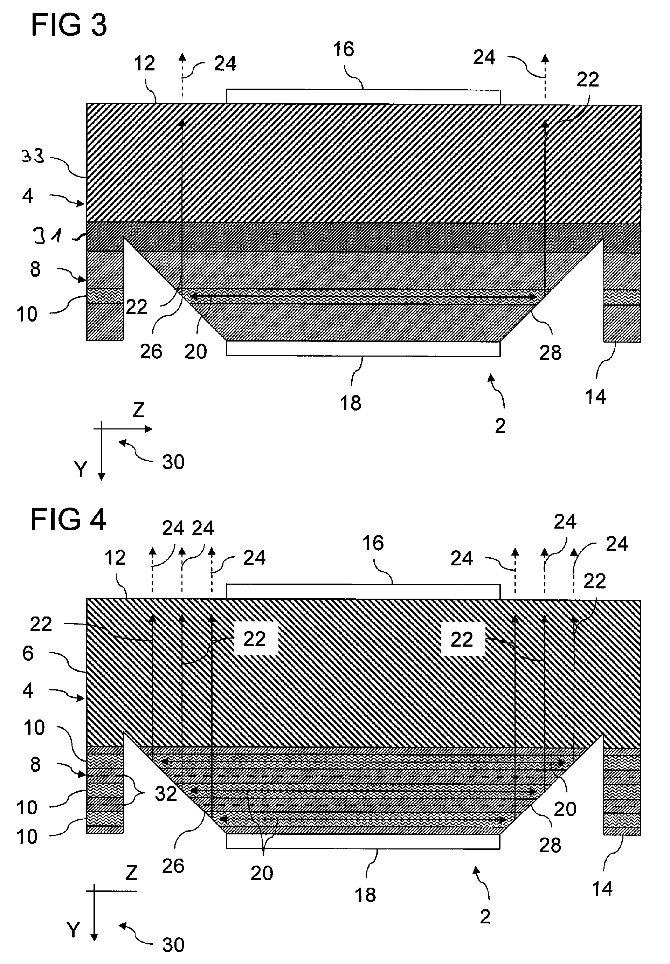

Die Funktionsschicht 6 kann beispielsweise eine Stromaufweitungsschicht 31 und/oder ein Aufwachssubstrat 33 umfassen (Figur 3). Die Stromaufweitungsschicht 31 kann beispielsweise epitaktisch auf dem Aufwachssubstrat 33 aufgewachsen werden. Die Stromaufweitungsschicht 31 weist parallel zu der aktiven Schicht 10 eine sehr hohe elektrische Leitfähigkeit auf. Dies bewirkt, dass sich Ladungsträger, die sich aufgrund der angelegten Spannung hin zu der Dünnfilmschichtenfolge 8 bewegen, auf die gesamte Fläche der aktiven Schicht 10 verteilen, insbesondere wenn die erste und/oder die zweite Elektrode 16, 18 lediglich einen kleinen Teil der ersten beziehungsweise zweiten planaren Oberfläche 12, 14 überdecken. Dies bewirkt, dass die Rekombination der Ladungsträger in der gesamten aktiven Schicht 10 stattfindet. Dies führt zu einer besonders wirkungsvollen Strahlungserzeugung in dem aktiven Bereich 10. Alternativ oder zusätzlich kann das Aufwachssubstrat 33 auch so ausgebildet sein, dass es die Funktion der Stromaufweitungsschicht 31 übernimmt.

Eine Intensität des oberflächenemittierenden Dünnfilm-Halbleiterlasers 2 kann weiter erhöht werden, indem zwei oder mehrere aktive Bereiche 10 vorgesehen sind (Figur 4). Die mehreren aktiven Bereiche 10 sind, entsprechend der Ausbildung mit einem einzelnen aktiven Bereich 10, vorzugsweise in mehrere Wellen- und Mantelschichten eingebettet und dadurch voneinander abgetrennt. Damit über die dadurch zwangsläufig zumindest teilweise in Sperrrichtung zueinander ausgerichteten pn- oder np-Übergänge, beispielsweise der Mantelschichten, dennoch ein Ladungsträgerübergang stattfindet, sind zwischen den entsprechenden in Sperrrichtung zueinander ausgerichteten pn- oder np-Übergängen Tunnelübergänge 32 ausgebildet. Die Tunnelübergänge ermöglichen ein Tunneln der Ladungsträger über die in Sperrrichtung geschalteten Übergänge. Dadurch kann eine Strahlungserzeugung des oberflächenemittierenden Dünnfilm-Halbleiterlasers 2 besonders wirkungsvoll verbessert werden. Die Tunnelübergänge 32 können beispielsweise durch hochdotierte Schichten realisiert werden. Derartige Tunnelübergänge sind beispielsweise für einen kantenemittierenden Halbleiterlaser aus US 5,212,706 bekannt.

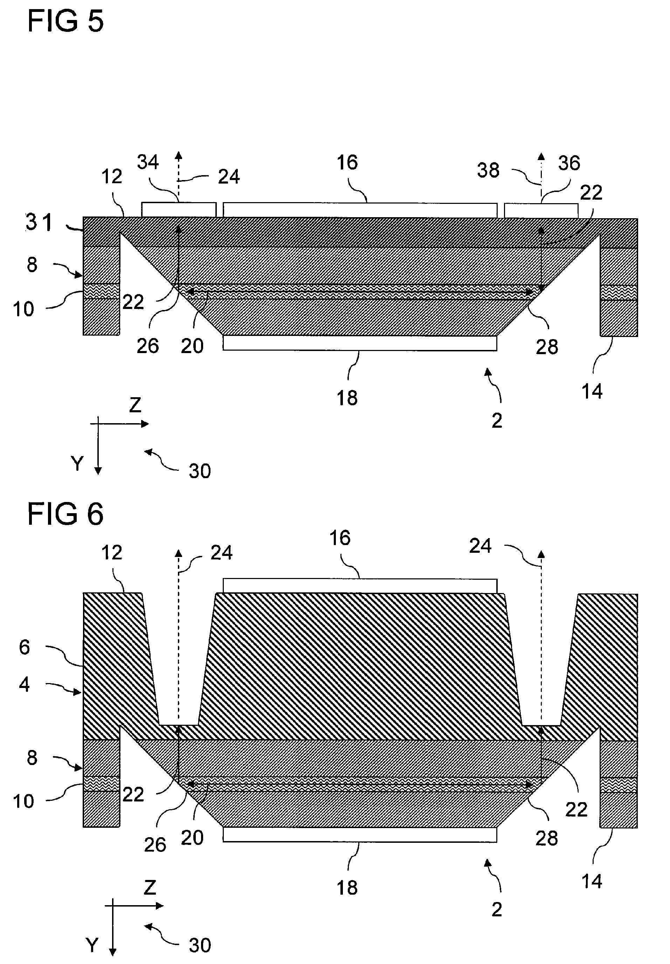

Alternativ dazu können alle Ausführungsformen des oberflächenemittierenden Dünnfilm-Halbleiterlasers 2 auch ohne die Funktionsschicht 6, insbesondere ohne das Aufwachssubstrat 33 und/oder die Stromaufweitungsschicht 31 ausgebildet sein (Figur 5). Dies bewirkt, dass die aus der aktiven Schicht 10 ausgekoppelte Strahlung innerhalb des Halbleiterkörpers 4 vorzugsweise möglichst wenig Weg zurücklegt und somit vorzugsweise möglichst wenig mit dem Halbleiterkörper 4 wechselwirkt. Dies kann dazu beitragen, die Intensität des oberflächenemittierenden Dünnfilm-Halbleiterlasers 2 zu erhöhen und den oberflächenemittierenden Dünnfilm-Halbleiterlaser 2 schmäler als 20 Mikrometer auszubilden.

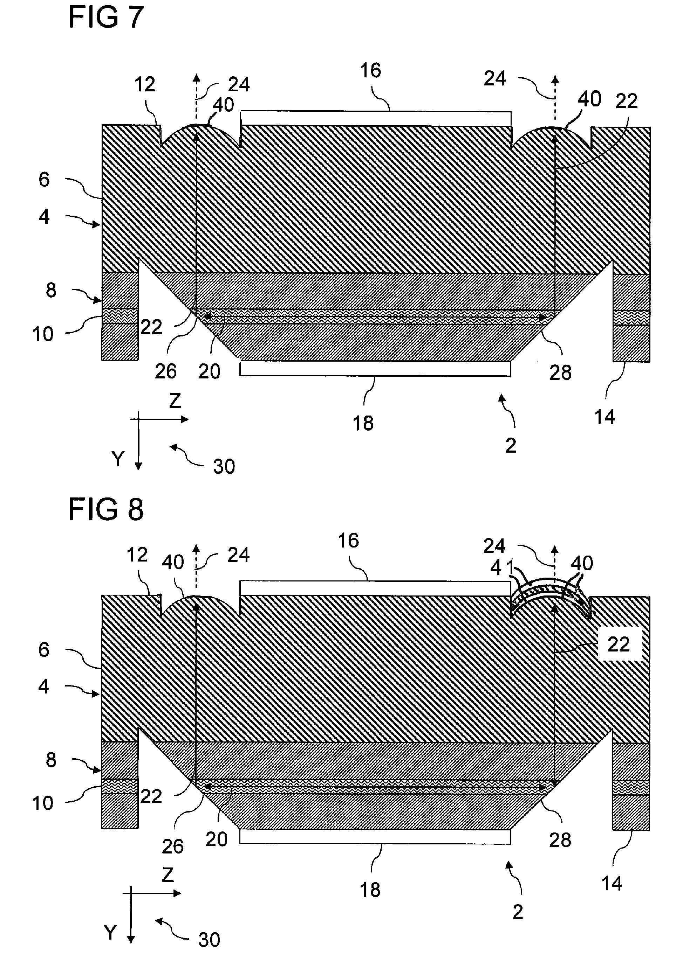

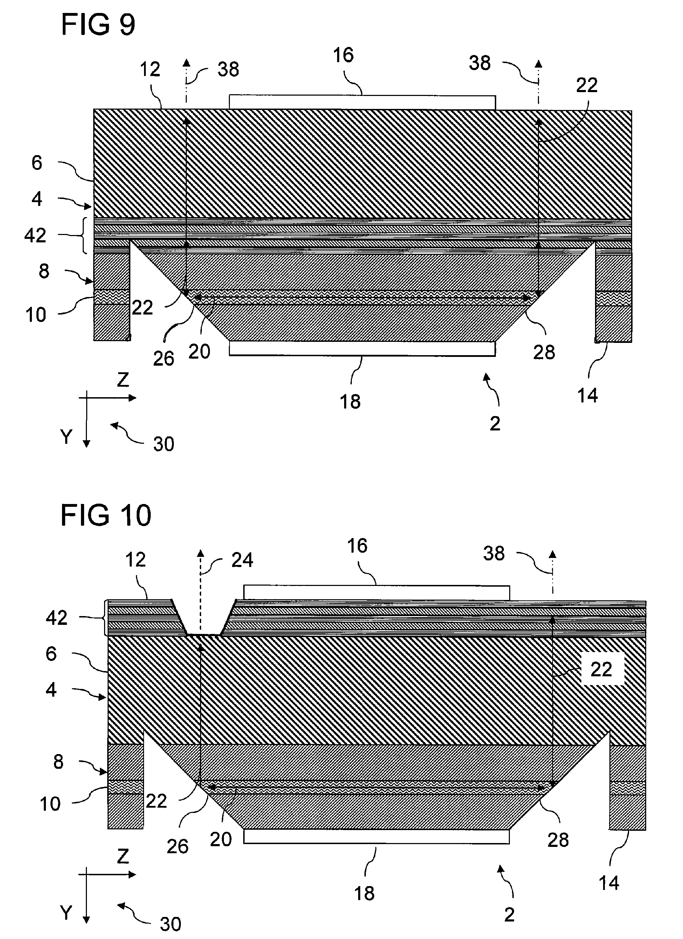

Ferner können zum Beeinflussen der von dem oberflächenemittierenden Dünnfilm-Halbleiterlaser 2 abgestrahlten Strahlung 24 eine, zwei oder mehrere optisch wirksame Schichten an ein, zwei oder mehreren Grenzflächen des Halbleiterkörpers 4 ausgebildet sein. Die optisch wirksamen Schichten dienen in diesem Zusammenhang dazu, eine Reflektion an der entsprechenden Grenzfläche zu erhöhen oder zu verringern. Dazu weisen die optisch wirksamen Schichten vorgegebene Brechungsindices auf, die bei unterschiedlichen optisch wirksamen Schichten unterschiedliche Werte haben können. Die optisch wirksamen Schichten umfassen beispielsweise eine erste und/oder zweite optisch wirksame Oberflächenschicht 34, 36, einen Braggspiegel 42 und/oder eine optisch wirksame Linsenschicht 41 (Figur 9, Figur 8). Die optisch wirksamen Schichten können eine Strahlungsausbeute pro aufgewendeter Energie beeinflussen. Ferner kann eine Energieschwelle, in anderen Worten Laserschwelle, ab der Laserstrahlung erzeugt wird, herabgesenkt werden. Ferner kann durch die optisch wirksamen Schichten eine Strahlungsleistung des oberflächenemittierenden Dünnfilm-Halbleiterlasers 2 bei einer vorgegebenen Versorgungsenergie eingestellt werden. Ferner können die optisch wirksamen Schichten genutzt werden, um eine Wellenlänge der aus dem oberflächenemittierenden Dünnfilm-Halbleiterlaser 2 austretenden Strahlung besonders präzise vorzugeben.

Die erste optisch wirksame Oberflächenschicht 34 kann beispielsweise eine Reflektion der aus dem aktiven Bereich ausgekoppelten Strahlung 22 an der ersten planaren Oberfläche 12 verringern.

Alternativ oder zusätzlich kann beispielsweise die zweite optisch wirksame Oberflächenschicht 36 eine Reflexion an der ersten planaren Oberfläche 12 des Halbleiterkörpers 4 erhöhen. Dabei kann die Reflexion durch die zweite optisch wirksame Oberflächenschicht 36 beispielsweise so weit erhöht werden, dass nahezu Totalreflexion an der Grenzfläche zwischen der ersten planaren Oberfläche 12 und der zweiten optisch wirksamen Schicht 36 stattfindet. Dies führt dazu, dass die aus der aktiven Schicht 10 ausgekoppelte Strahlung 22 zurück in die aktive Schicht 10 reflektiert wird. Dies bewirkt, dass die Strahlung 24 nur in einem kleinen Austrittsbereich aus dem Halbleiterkörper austritt. Eine durch die zweite optisch wirksame Schicht ausgetretene abgeschwächte Strahlung 38 kann dann vernachlässigt werden. Ferner kann dadurch die Laserschwelle abgesenkt werden, bei der Laserstrahlerzeugung auftritt. Alternativ dazu kann auch nur eine der beiden optisch wirksamen Oberflächenschichten vorgesehen sein.

Geringe Wechselwirkung der aus der aktiven Schicht 10 ausgekoppelten Strahlung 22 in dem Halbleiterkörper 4 kann beispielsweise auch dadurch erreicht werden, dass die Funktionsschicht 6 in einem Bereich, in dem während des Betriebs des Halbleiterlasers 4 ein Hauptstrahlungsfluss auftritt, schmäler ist, als außerhalb des Bereichs (Figur 6).

Die Strahlung kann beim Austreten aus dem Halbleiterkörper 4 durch eine oder zwei Linsen 40 fokussiert und/oder defokussiert werden (Figur 7). In Zusammenhang mit der oder den Linsen 40 kann es vorteilhaft sein, wenn die Linsen 40 weit von den Spiegelflächen 26, 28 entfernt sind. Dies kann durch ein relativ dickes Aufwachssubstrat 33 erreicht werden.

Die Linsen 40, die Spiegelflächen 26, 28 und/oder die Verschmälerung der Funktionsschicht 6 werden vorzugsweise durch Ätzverfahren ausgebildet.

Die Ausführungsformen können beispielsweise auch so kombiniert werden, dass auf eine oder mehrere Linsen 40 die eine oder mehrere optisch wirksame Linsenschichten 41 aufgebracht werden (Figur 8). Die optisch wirksame Linsenschicht 41 kann auch als dielektrischer Spiegel bezeichnet werden.

Der Braggspiegel 42 kann beispielsweise durch epitaktisches Wachstum monolithisch in dem Halbleiterkörper 4 integriert sein (Figur 9). Dabei kann es vorteilhaft sein, wenn der Braggspiegel 42 vorzugsweise möglichst nah an den Spiegelflächen 26, 28 und oder der aktiven Schicht 10 ausgebildet ist, da dann ein besonders hoher Anteil der aus der aktiven Schicht 10 ausgekoppelten Strahlung zurück in die aktive Schicht 10 reflektiert wird. Der Braggspiegel 42 zeichnet sich dadurch aus, dass seine Reflektivität vom Einfallswinkel der Strahlung zu einer Oberflächennormalen des Braggspiegels 42 und von einer Wellenlänge der Strahlung abhängt. Vorzugsweise ist das Halbleitermaterial des Braggspiegels 42 dotiert, und zwar entsprechend den anderen dotierten Schichten, beispielsweise der Mantelschicht, auf derselben Seite der aktiven Schicht 10. Damit der Braggspiegel 42 hochreflektierend wirkt, z.B. mit einer Reflektivität von mehr als 95 % für senkrechten Strahlungseinfall, ist der Braggspiegel 42 vorzugsweise aus einer Vielzahl von übereinander angeordneten Schichten gebildet. Die Reflektivität des Braggspiegels 42 kann über die Anzahl an Schichten eingestellt werden. Die für eine vorgegebene Reflektivität benötigte Schichtzahl steigt stark nichtlinear mit wachsender vorgegebener Reflektivität. Falls der in einer Strahlungsrichtung hintereinander der Braggspiegel 42 und eine der anderen optisch wirksamen Schichten ausgebildet ist, so kann der Braggspiegel 24 mit einer geringeren Anzahl an Schichten ausgebildet sein. Dadurch können Epitaxiezeiten und somit Herstellungskosten verringert werden.

Alternativ dazu kann der Braggspiegel 42 auf die Funktionsschicht 6 oder das Aufwachssubstrat 33 aufgewachsen werden 10. Dabei kann der Braggspiegel 42 sowohl innerhalb des Halbleiterkörpers 4 als auch aufgewachsen auf der Funktionsschicht 6 einen Bereich umfassen, in dem der Braggspiegel 42 schmaler oder gar nicht vorhanden ist (Figur 10). Dies bewirkt wiederum nur eine Beeinflussung der Strahlung mittels des Braggspiegels 42 auf einer Seite der austretenden Strahlung 38 und kann somit im Sinne der optische wirksamen Schicht dazu beitragen, die Energieschwelle abzusenken.

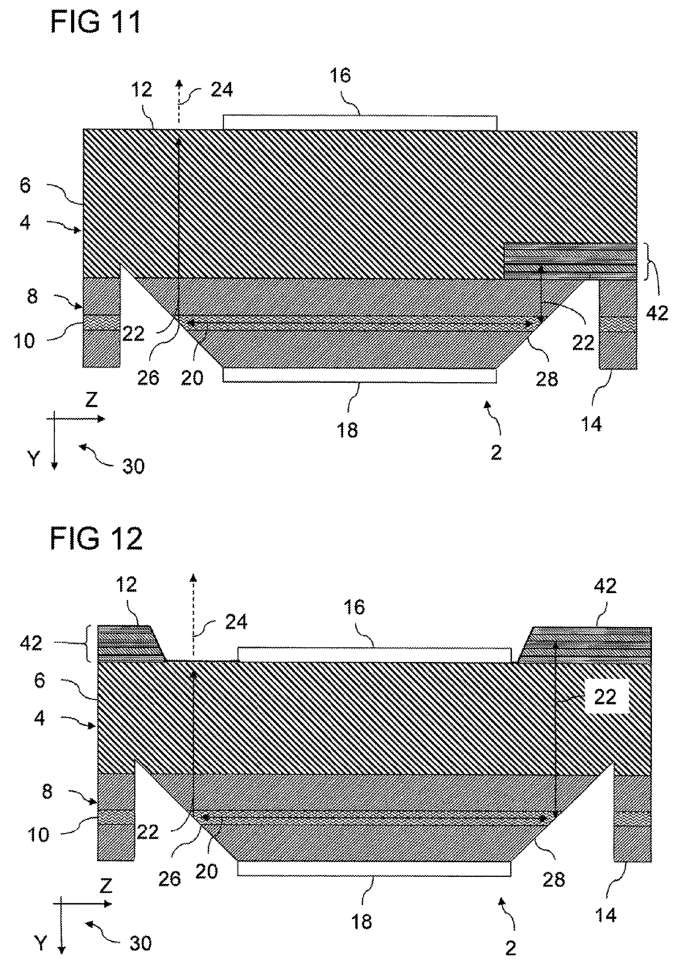

Der Braggspiegel 42 kann auch innerhalb des Halbleiterkörpers 4 lediglich in einem Gebiet des auftretenden Hauptstrahlungsflusses ausgebildet sein (Figur 11). Dies kann beim Herstellungsprozess beispielsweise durch laterale feuchtthermische Oxidation des Braggspiegels beispielsweise über ein Loch in dem Wafer erzielt werden. Alternativ dazu kann ein falscher und/oder verstimmter Braggspiegel aufgewachsen werden, der dann durch feucht-thermische Oxidation in einem vorgegebenen Bereich in den Braggspiegel 42 umgewandelt wird. Die feuchtthermische Oxidation ist beispielsweise aus US 5,696,023 bekannt.

Falls der Braggspiegel 42 auf der Funktionsschicht 6 so aufgewachsen wird, dass er die erste planare Oberfläche 42 des Halbleiterkörpers 4 bildet (Figur 12), so kann der Braggspiegel 42 auch keinen Überlappungsbereich mit der ersten Elektrode 16 aufweisen. Dies bewirkt, dass der Ladungsträgertransport nicht durch den Braggspiegel 42 über den Braggspiegel 42 stattfindet und weniger Wechselwirkungen unterliegt. Dies kann dazu beitragen, dass die angelegte Spannung niedrig gewählt werden kann bei vorgegebener Strahlungsleistung.

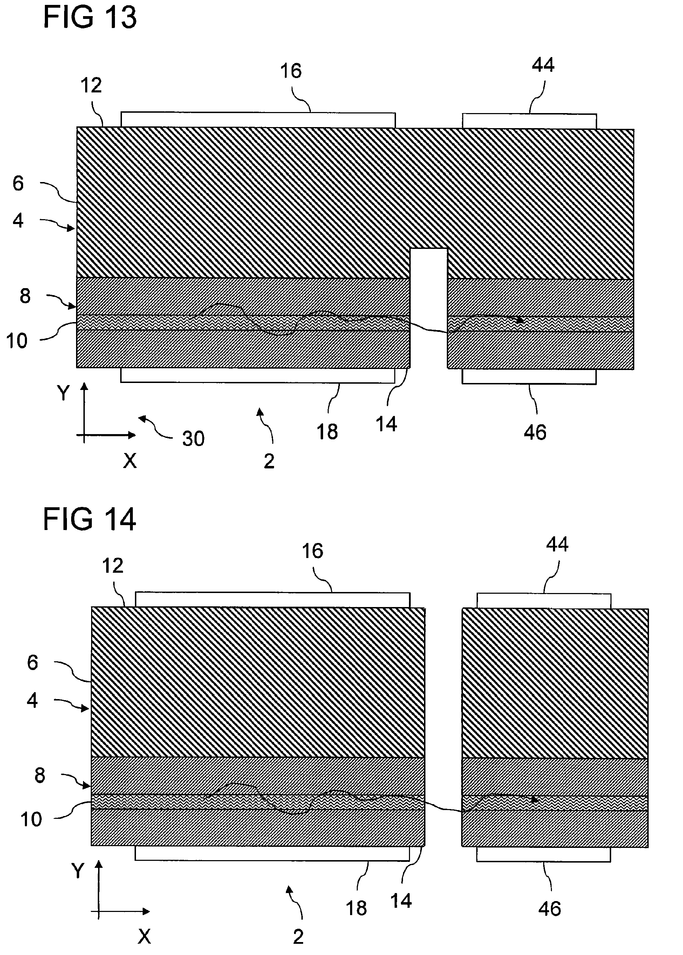

Zum Erfassen der erzeugten Strahlung kann in einer Richtung senkrecht zu einer Verbindungslinie zwischen den beiden Spiegelflächen 26, 28 ein Monitorbereich des oberflächenemittierenden Dünnfilm-Halbleiterlasers 2 vorgesehen sein (Figur 13). Der Monitorbereich ist zumindest durch eine Unterbrechung der aktiven Schicht 10 von einem Strahlungserzeugungsbereich des oberflächenemittierenden Dünnfilm-Halbleiterlasers 2 abgetrennt. Der Monitorbereich ist zwischen einer ersten und einer zweiten Monitorelektrode 44, 46 ausgebildet. Der Strahlungserzeugungsbereich ist zwischen der ersten und der zweiten Elektrode 16, 18 ausgebildet. Ferner wird an der ersten Monitorelektrode 44 und an der zweiten Monitorelektrode 46 lediglich eine Spannung und/oder ein Strom gemessen oder es wird ein Strom und/oder eine Spannung mit entgegen gesetzter Polung zu den beiden Elektroden in dem Strahlungserzeugungsbereich angelegt und die tatsächlich anliegende Spannung beziehungsweise der tatsächlich anliegende Strom erfasst. Abhängig von der erfassten Spannung beziehungsweise dem erfassten Strom kann dann die Strahlungserzeugung in der aktiven Schicht 10 des Strahlungserzeugungsbereichs des oberflächenemittierenden Dünnfilm-Halbleiterlasers 2 ermittelt werden. Dadurch kann die Strahlungserzeugung erfasst und/oder geregelt werden. Somit dient die aktive Schicht 10 in dem Monitorbereich als Sensor für die Strahlung aus der aktiven Schicht 10.

Alternativ dazu kann der Monitorbereich vollständig von dem Strahlungserzeugungsbereich abgetrennt sein (Figur 14). In diesem Zusammenhang ist jedoch vorzugsweise die zweite planare Oberfläche 14 des Strahlungserzeugungsbereichs und des Monitorbereichs über das gemeinsames Trägersubstrat miteinander gekoppelt.

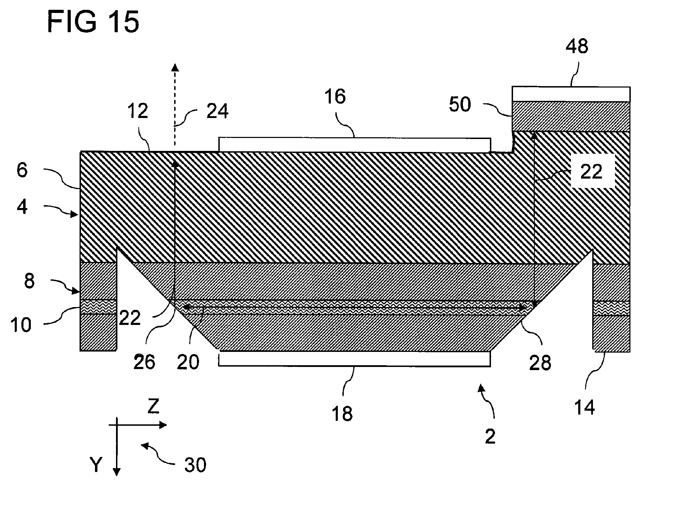

Der Monitorbereich kann auch ausgebildet werden, indem eine strahlungsreaktive Schicht 50 mit der ersten planaren Oberfläche 12 des Halbleiterkörpers 4 gekoppelt ist, wobei dann auf der strahlungsreaktiven Schicht 50 eine dritte Monitorelektrode vorgesehen ist (Figur 15). Die über die zweite Spiegelfläche 28 aus der aktiven Schicht 10 ausgekoppelte Strahlung 22, wird dann vorzugsweise zu dem strahlungsreaktiven Bereich 50 abgelenkt und induziert eine Spannung zwischen der zweiten Elektrode 18 und der dritten Monitorelektrode 48. Mittels dieser Spannung kann die Strahlungserzeugung innerhalb der aktiven Schicht 10 ermittelt und/oder geregelt werden. Zusätzlich kann zwischen der strahlungsreaktiven Schicht 50 und der Dünnfilmschichtenfolge 8 ein Braggspiegel 42 ausgebildet sein, durch den dann nur Strahlung mit einer vorgegebenen Wellenlänge gelangt und von der strahlungsreaktiven Schicht 50 und der dritten Monitorelektrode 48 erfasst wird und/oder durch den die Strahlung zumindest teilweise zurück in die aktive Schicht 10 reflektiert wird.

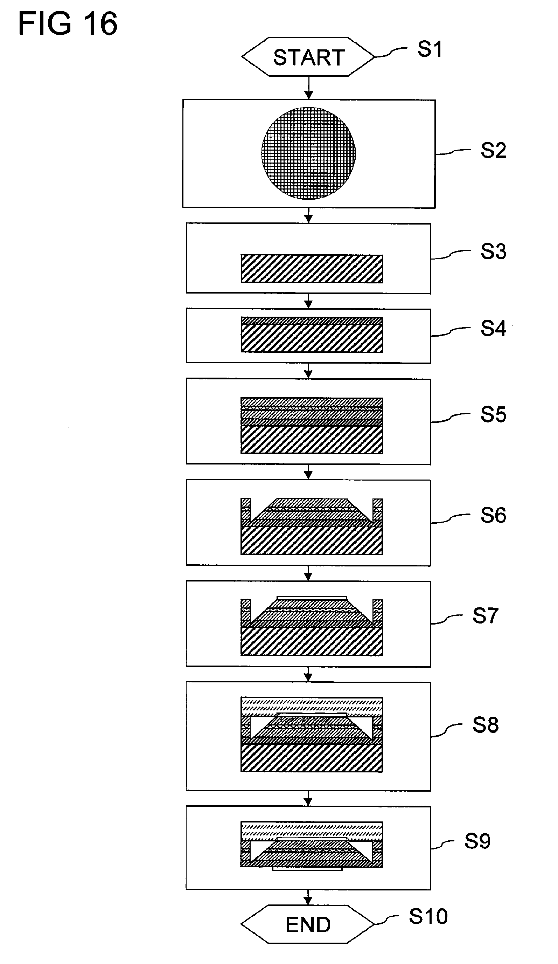

Ein Verfahren zum Herstellen des oberflächenemittierenden Dünnfilm-Halbleiterlasers 4 wird vorzugsweise in einem Schritt S1 gestartet (Figur 16), in dem beispielsweise ein Material für den Wafer hergestellt wird. Das Material für den Wafer kann beispielsweise Gallium-Arsenid umfassen und/oder mit Silizium dotiert sein.

In einem Schritt S2 wird der Wafer, der beispielsweise das Aufwachssubstrat 33 repräsentiert, ausgeschnitten und für die weitere Behandlung vorbereitet. Das Aufwachssubstrat 33 kann beispielsweise eine Dicke von 600 Mikrometer aufweisen.

In einem Schritt S3 wird der Wafer, beispielhaft an einem der oberflächenemittierenden Dünnfilm-Halbleiterlaser 4 des Wafers dargestellt, in dem Waferverbund in eine Vorrichtung zum epitaktischen Schichtwachstum eingebracht.

In einem Schritt S4 kann die Stromaufweitungsschicht 31 epitaktisch auf das Aufwachssubstrat 33 aufgewachsen werden. Davor kann eine Ätzstoppschicht auf dem Aufwachssubstrat 33 ausgebildet werden.

In einem Schritt S5 wird die Dünnfilmschichtenfolge 8 mit der aktiven Schicht 10 auf die Stromaufweitungsschicht 31 epitaktisch aufgewachsen.

In einem Schritt S6 werden mittels Photolack und Ätzverfahren die Spiegelflächen 26, 28 ausgebildet. Ferner können in dem Schritt S6 die planaren Oberflächen im Austrittsbereich der Strahlung und/oder die Spiegelflächen 26, 28 passiviert werden.

In einem Schritt S7 kann die zweite Elektrode 18 auf die Dünnfilmschichtenfolge 8 aufgebracht werden.

In einem Schritt S8 wird ein Trägersubstrat mit der zweiten planaren Oberfläche 14 des Halbleiterkörpers 4 gekoppelt. Das Trägersubstrat kann beispielsweise Metall und/oder Germanium umfassen. Beispielsweise wird der gesamte Wafer mit der Dünnfilmschichtenfolge 8 auf das Trägersubstrat gelötet.

In einem Schritt S9 wird vorzugsweise das Aufwachssubstrat 33 zumindest teilweise entfernt, beispielsweise durch ein chemisches Ätzverfahren, und die erste Elektrode 31 mit dem Halbleiterkörper 4 gekoppelt. Ohne das Aufwachssubstrat 33 kann der oberflächenemittierende Dünnfilm-Halbleiterlaser 2 schmäler als 20 Mikrometer sein.

In einem Schritt S10 kann das Verfahren zum Herstellen des oberflächenemittierenden Dünnfilm-Halbleiterlasers 2 beendet werden, indem der Halbleiterlaser 4 aus dem Waferverbund herausgelöst wird.

Alternativ oder zusätzlich können während des Verfahren zum Herstellen des oberflächenemittierenden Dünnfilm-Halbleiterlasers 2 noch weitere Schritte abgearbeitet werden. Beispielsweise kann die strahlungsreaktive Schicht 50 durch epitaktisches Wachstum auf das Aufwachssubstrat 33 aufgebracht werden. Daraufhin kann die Stromaufweitungsschicht 31 auf das Aufwachssubstrat 33 und die strahlungsreaktive Schicht 50 aufgebracht werden. Dann wird die Dünnfilmschichtenfolge 8 durch epitaktisches Wachstum auf der Stromaufweitungsschicht 31 ausgebildet. Nach Entfernen des Aufwachssubstrats 33 kann dann die strahlungsreaktive Schicht 50 außerhalb des Bereichs entfernt werden, der für die dritte Monitorelektrode 48 vorgesehen ist, entfernt werden. Außerhalb der strahlungsreaktiven Schicht 50 wird dann die erste Elektrode 16 ausgebildet und auf der strahlungsreaktiven Schicht 50 wird dann die dritte Monitorelektrode 48 ausgebildet.

Der oberflächenemittierende Dünnfilm-Halbleiterlaser 2 kann an einer zu dem Trägersubstrat hin gewandten ersten Hauptfläche der strahlungserzeugenden Dünnfilmschichtenfolge 8 eine reflektierende Schicht aufweisen, die zumindest einen Teil der in der Dünnfilmschichtenfolge 8 erzeugten elektromagnetischen Strahlung in diese zurückreflektiert.

Diese Patentanmeldung beansprucht die Priorität der deutschen Patentanmeldung DE 10 2007 046 518.3 und DE 10 2007 062 050.2, deren Offenbarungsgehalt hiermit durch Rückbezug aufgenommen wird.

## Patentansprüche

1. Halbleiterlaser, der als oberflächenemittierender Dünnfilm-Halbleiterlaser mit einem Halbleiterkörper (4) ausgebildet ist, der
- eine erste und eine zweite planare Oberfläche (12, 14) umfasst,
- zwischen den planaren Oberflächen zur Erzeugung von Strahlung zumindest eine aktive Schicht (10) umfasst,
- zum Auskoppeln der Strahlung aus der aktiven Schicht (10) hin zu der ersten planaren Oberfläche (12) zumindest eine zu der aktiven Schicht (10) geneigte erste Spiegelfläche (26) aufweist.

2. Halbleiterlaser nach Anspruch 1, bei dem der Halbleiterkörper (4), zum Auskoppeln von Strahlung aus der aktiven Schicht (10) hin zu der ersten planaren Oberfläche (12) eine zu der aktiven Schicht (10) geneigte zweite Spiegelfläche (28) aufweist.

3. Halbleiterlaser nach einem der vorstehenden Ansprüche, bei dem die Dünnfilmschichtenfolge (8) zwei oder mehrere aktive Schichten (10) umfasst, in denen die Strahlung erzeugt wird und die durch in der Dünnfilmschichtenfolge (8) monolithisch integrierte Tunnelübergänge (32) elektrisch miteinander gekoppelt sind.

4. Halbleiterlaser nach einem der vorstehenden Ansprüche, bei dem der Halbleiterkörper (4) eine Funktionsschicht (6) umfasst, deren von der Dünnfilmschichtenfolge (8) abgewandte Seite die erste planare Oberfläche (12) des Halbleiterkörpers (4) bildet, und bei dem die Funktionsschicht (6) in einem Gebiet schmaler ist, in dem während eines Betriebs des oberflächenemittierenden Dünnfilm-Halbleiterlasers (2) ein Hauptstrahlungsfluss aus der aktiven Schicht (10) ausgekoppelter Strahlung auftritt, als außerhalb des Gebiets.

5. Halbleiterlaser nach Anspruch 4, bei dem die Funktionsschicht (6) eine Stromaufweitungsschicht (31) oder ein Aufwachssubstrat (33) umfasst.

6. Halbleiterlaser nach einem der vorstehenden Ansprüche, bei dem der Halbleiterkörper (4) mit seiner zweiten planaren Oberfläche (18) mit einem Trägersubstrat gekoppelt ist.

7. Halbleiterlaser nach einem der vorstehenden Ansprüche, der an zumindest einer ersten und/oder einer zweiten Grenzfläche des Halbleiterkörpers (4) zumindest eine erste und/oder zweite optisch wirksame Schicht mit einem vorgegebenen ersten Reflexionsgrad umfasst, die so angeordnet ist, dass aus der aktiven Schicht (10) ausgekoppelte Strahlung mittels der ersten und/oder zweiten Spiegelfläche (26) hin zu der ersten und/oder zweiten optisch wirksamen Schicht gespiegelt wird.

8. Halbleiterlaser nach Anspruch 7, bei dem zumindest eine der Grenzflächen durch eine der optisch wirksamen Schichten und die erste planare Oberfläche (12) gebildet ist oder bei dem der Halbleiterkörper (4) zumindest eine der optisch wirksamen Schichten umfasst.

9. Halbleiterlaser nach einem der vorstehenden Ansprüche, bei dem der Halbleiterkörper (4) zumindest eine erste Linse (40) umfasst, die so ausgebildet ist, dass ein Hauptstrahlungsfluss der aus der aktiven Schicht (10) ausgekoppelten Strahlung die erste Linse (40) durchdringt.

10. Halbleiterlaser nach einem der Ansprüche 2 bis 9, der einen Strahlungserzeugungsbereich des Halbleiterkörpers (4)umfasst, über den eine erste und eine zweite Elektrode (16, 18) elektrisch miteinander gekoppelt sind, und der einen Monitorbereich des Halbleiterkörpers (4) zum Detektieren von Strahlung aus der aktiven Schicht (10) umfasst, der zumindest durch eine Unterbrechung der Dünnfilmschichtenfolge (8) von dem Strahlungserzeugungsbereich abgetrennt ist und über den eine erste und eine zweite Monitorelektrode (44, 46) miteinander elektrisch gekoppelt sind, und wobei der Monitorbereich insbesondere, bezüglich einer Verbindungslinie zwischen erster (26) und zweiter geneigter Spiegelfläche (28), lateral zur aktiven Schicht (10) versetzt ist,
oder dessen Halbleiterkörper (4) alternativ einen Strahlungserzeugungsbereich umfasst, über den eine erste und eine zweite Elektrode (16, 18) elektrisch miteinander gekoppelt sind, und dessen Halbleiterkörper (4) einen Monitorbereich umfasst, der eine dritte Monitorelektrode (48) und eine strahlungsreaktive Schicht (50) an der dritten Monitorelektrode (48) umfasst, die so ausgebildet ist, dass Strahlung, die mittels der zweiten Spiegelfläche (28) aus dem aktiven Bereich (8) ausgekoppelt wird, hin zu der strahlungsreaktiven Schicht (50) gespiegelt wird.

11. Verfahren zum Herstellen des Halbleiterlasers nach einem der vorstehenden Ansprüche, der als oberflächenemittierender Dünnfilm-Halbleiterlaser (2) ausgebildet ist, bei dem
- der Halbleiterkörper (4) durch epitaktisches Wachstum der Dünnfilmschichtenfolge (8) auf dem Aufwachssubstrat (33) ausgebildet wird, wobei die zweite planare Oberfläche (14) des Halbleiterkörpers (4) von dem Aufwachssubstrat (33) abgewandt ist,
- zumindest die erste Spiegelfläche (26) von der zweiten planaren Oberfläche (14) aus durch Entfernen von Halbleitermaterial aus der Dünnfilmschichtenfolge (8) gebildet wird.

12. Verfahren nach Anspruch 11, bei dem das Trägersubstrat auf die zweite planare Oberfläche (14) aufgebracht wird und bei dem das Aufwachssubstrat (33) von dem aktiven Bereich (8) abgetrennt wird.

13. Verfahren nach einem der Ansprüche 11 oder 12, bei dem der oberflächenemittierende Dünnfilm-Halbleiterlaser (2) im Waferverbund hergestellt wird und bei dem der Dünnfilm-Halbleiterlaser (2) nach Aufbringen des Trägersubstrats aus dem Waferverbund herausgelöst wird.

14. Verfahren nach einem der Ansprüche 12 oder 13, bei dem vor dem Aufbringen des Trägersubstrats zumindest die zweite Elektrode (18) auf die zweite planare Oberfläche (14) des Halbleiterkörpers (4) aufgebracht wird.

15. Verfahren nach einem der Ansprüche 12 bis 14, bei dem
- vor dem Aufwachsen der Dünnfilmschichtenfolge (8) die strahlungsreaktive Schicht (50) durch epitaktisches Wachstum auf das Aufwachssubstrat (33) aufgebracht wird,
- die Stromaufweitungsschicht (31) auf die strahlungsreaktive Schicht (50) aufgebracht wird,
- die Dünnfilmschichtenfolge (8) durch epitaktisches Wachstum auf der Stromaufweitungsschicht (31) ausgebildet wird,
- nach dem Entfernen des Aufwachssubstrats (33) die strahlungsreaktive Schicht (50) außerhalb des Bereichs entfernt wird, der für die dritte Monitorelektrode (48) vorgesehen ist,
- außerhalb der strahlungsreaktiven Schicht (50) die erste Elektrode (16) auf der Funktionsschicht (6) ausgebildet wird
- die dritte Monitorelektrode auf der strahlungsreaktiven Schicht (50) ausgebildet wird.
